# EUROPEAN PATENT SPECIFICATION

(11) **EP 1 834 412 B1**
(45) Date of publication and mention of the grant of the patent: **03.06.2009**
(21) Application number: 05857336.1
(22) Date of filing: 12.09.2005
(51) Int. Cl.: H04B 1/28, H03D 7/16

(54) **LOW INTERMEDIATE FREQUENCY (IF) RADIO RECEIVER CIRCUITS**
FUNKEMPFÄNGERSCHALTUNGEN MIT NIEDRIGER ZWISCHENFREQUENZ (ZF)
CIRCUITS DE RECEPTEURS RADIO A BASSE FREQUENCE INTERMEDIAIRE (IF)

(30) Priority: 20.09.2004 GB 0420842
(43) Date of publication of application: 19.09.2007
(73) Proprietor: Frontier Silicon Limited, Cambridge Cambridgeshire CB2 4LJ (GB)
(72) Inventor: LUFF, Gwilym Francis, Frontier Silicon Limited, Cambridge Cambridgeshire CB2 4LJ (GB)
(74) Representative: Martin, Philip John
(86) International application number: PCT/GB2005/050150
(87) International publication number: WO 2006/085046

(56) References cited:
- EP-A- 0 782 249
- CROLS J ET AL: "AN ANALOG INTEGRATED POLYPHASE FILTER FOR A HIGH PERFORMANCE LOW-IF RECEIVER" 1995 SYMPOSIUM ON VLSI CIRCUITS. KYOTO, JUNE 8 - 10, 1995, SYMPOSIUM ON VLSI CIRCUITS, NEW YORK, IEEE, US, 8 June 1995 (1995-06-08), pages 87-88, XP000557814 ISBN: 0-7803-2600-8 cited in the application
- CROLS J ET AL: "A SINGLE-CHIP 900 MHZ CMOS RECEIVER FRONT-END WITH A HIGH PERFORMANCE LOW-IF TOPOLOGY" IEEE JOURNAL OF SOLID-STATE CIRCUITS, IEEE SERVICE CENTER, PISCATAWAY, NJ, US, vol. 30, no. 12, December 1995 (1995-12), pages 1483-1492, XP000557254 ISSN: 0018-9200 cited in the application
- WRIGHT A R ET AL: "I/Q mismatch compensation in zero-IF OFDM receivers with application to dab" 2003 IEEE INTERNATIONAL CONFERENCE ON ACOUSTICS, SPEECH, AND SIGNAL PROCESSING. PROCEEDINGS. (ICASSP). HONG KONG, APRIL 6 - 10, 2003, IEEE INTERNATIONAL CONFERENCE ON ACOUSTICS, SPEECH, AND SIGNAL PROCESSING (ICASSP), NEW YORK, NY : IEEE, US, vol. VOL. 1 OF 6, 6 April 2003 (2003-04-06), pages 329-332, XP010640948 ISBN: 0-7803-7663-3

## Description

This invention relates to apparatus and methods for radio receivers, in particular so-called low (IF) frequency receivers. Embodiments of the invention are particularly suitable for digital audio broadcast receivers.

Intermediate frequency receivers have been in use for many years, the best known example of such a receiver being the superheterodyne receiver. In a superhet receiver the desired or target rf signal is downconverted to an intermediate frequency by mixing or multiplying the received signal by a simple sinusoidal signal from a local oscillator. The desired or target rf signal can be demodulated at this intermediate frequency or further downcoverted prior to modulation. A plurality of successive downconversion stages may be employed.

The local oscillator frequency is selected to be equal to a difference between the frequency of the target rf signal and the intermediate frequency. However the mixing process results in an unwanted response to a so-called image signal, the target and image signals lying on opposite sides of the local oscillator frequency. Thus a conventional superhet includes a high Q image reject filter prior to the mixer, or a tunable receiver, which must itself be tunable. Such a high Q filter is difficult and expensive to fabricate and because, a combination of capacitors and inductors is normally required, difficult to integrate.

In recent years single chip integrated radio receivers have been fabricated in CMOS by employing a zero-IF topology. Such a receiver is also known as a homodyne or direct conversion receiver. In a zero-IF receiver the IF frequency is chosen to be zero so that the target and image coincide. This relaxes the image rejection ratio requirements and dispenses with the need for an off-chip image reject filter. However it is then necessary to, in effect, capture the spectrum to either side of dc, which is done by employing quadrature downconversion, that is by employing a local oscillator with a quadrature (sine and cosine) output and a quadrature mixer to provide a pair of IF signals, one in phase quadrature with the other. By employing quadrature signal processing positive and negative frequency components can be separated.

The main advantage of a zero-IF receiver is that this topology dispenses with the need for a high Q, tunable, bandpass filter prior to the mixer; instead a low-pass filter is employed once the received signal has been downconverted. However this architecture suffers from a number of drawbacks including *de* offsets in the downconverted signal due to self-mixing (the receiver receiving signals from its own local oscillator), second-order distortion due to mixer non-linearity, and 1/f (*dc*) noise. An example of a zero-IF receiver is described in US 4, 653,117, which describes the use of a phase lock technique to precisely centre the zero-IF signal to avoid problems such as a beat note which arises when the IF frequency is not exactly zero.

More recently it has been recognized that so-called low-IF receivers can overcome the above mentioned drawbacks of direct conversion receivers (Low-IF receivers are sometimes also referred to as near-zero IF receivers, and in this specification the two terms are used synonymously). A low-IF receiver has an IF frequency which is between 0.1 and 10 times the bandwidth of the target rf signal, more typically less than 5, less than 3, or between 1 and 2 times the bandwidth of the target rf signal. At first sight it would appear that such a configuration would require an image reject filter before the mixer with an impossibly high Q but it was recognized that, in fact, rf image rejection could be postponed to the IF stage.

Two basic techniques are known. The first is to use an image-rejecting I/Q mixer that provides quadrature outputs to a pair of separate, matched IF filters. These introduce an additional 90 degrees phase shift between the target and image signals, so that when the filtered signals are combined the image signals are 180 degrees out of phase with one another and cancel. However a preferred technique, which reduces the filter matching requirement, is to filter the quadrature mixer output using a so-called polyphase filter.
A polyphase filter receives an n-phase (or polyphase) input and provides an n-phase output; a quadrature filter is a special case of this where n=4.

A polyphase filter distinguishes between positive and negative frequencies, that is it has a frequency response which depends upon a phase difference between its two (or more) input signals. Thus a polyphase bandpass filter can be employed which has a passband centred on the target and which rejects the image signal. Since, in a low-IF receiver, the received signal bandwidth is comparable with the IF frequency only a low Q filter (say Q=1 or 2) is required. Furthermore, unlike a conventional low-Q band pass filter, the frequency response is substantially symmetrical about a centre frequency of the pass band which, for a data receiver, helps to maintain an undistorted eye diagram for the received data. Further, a polyphase filter can be constructed using only resistors and capacitors, that is without inductors, making it suitable for monolithic integration.

Examples of polyphase filters are described in US 6,441,682 and US 4,914,408; background information on polyphase filters can also be found in "Using Polyphase Filters as Image Attenuators", RF Design, June 2001, pages 26 - 34, Tom Homack.

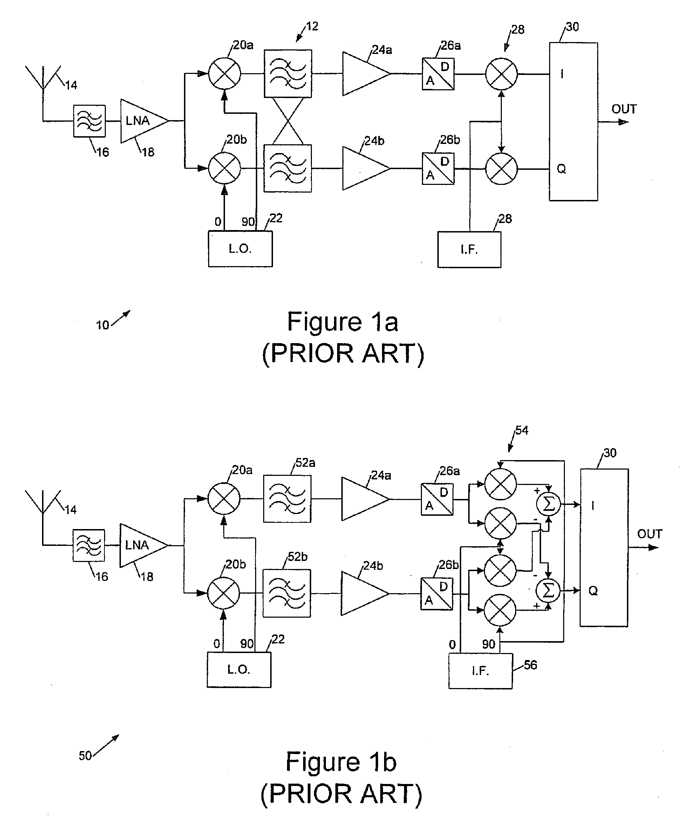

Referring to figures 1a and 1e these show example topologies of a known low-IF receiver, figure 1a showing a receiver 10 incorporating a polyphase filter 12, and figure 1b showing a receiver 50 which uses a pair of band pass IF filters 52a, b in me IF processing. Both receivers comprise a receive antenna 14 coupled to a band select filter 16 and low noise amplifier 18, followed by a quadrature downconversion mixer 20a, b, which also has a quadrature input from a local oscillator 22. In the receiver 10 of figure 1 a quadrature mixer 20 is followed by the polyphase (quadrature) mixer 12 and then by a pair of further amplifiers 24a, b and a pair of analog-to-digital converters 26a, b. There is a similar arrangement in the receiver 50 of figure 1b except that a matched pair of IF filters 52a, b is employed. However in the digital domain, in receiver 10 an IF oscillator 28 provides a single phase output at the IF frequency for a pair of mixers 28 to downconvert to base band prior to demodulation 30, whereas in receiver 50 a complex mixer 54 is employed to mix the IF signal with a quadrature signal at the IF frequency from oscillator 56 prior to demodulation 30.

Another example of known receivers using a first, non-zezo IF and a second intermediate frequency higher than the first can be found in EP 0,782,249.

There exists a general need to improve upon these known low-IF receiver topologies, more particularly by aiming to improve image and/or interference rejection whilst reducing the filtering requirements in the analog domain.

According to the present invention there is therefore provided a low IF radio receiver for receiving digital audio broadcasts, the circuit comprising: an rf input for a received rf signal; a first local having a quadrature output to provide a quadrature first local oscillator signal at a first frequency, a quadrature first coupled to said rf input and to said quadrature output of said first local oscillator and having a quadrature first mixer output, said first mixer and said first local oscillator being configured to provide quadrature mixing of said quadrature first local oscillator signal and said received rf signal to downconvert said received rf signal to a first quadrature IF signal at a first IF frequency; a bandpass filter coupled to said quadrature first mixer output and having a filtered output to provide a bandpass filtered first IF signal; a second local oscillator having a second local oscillator output, to provide a second local oscillator signal at a second frequency; a second miser coupled to said filtered output of said bandpass filter and to said second local oscillator and having a second mixer output, said second mixer and said second local oscillator being configured to provide mixing of said second local oscillator signal and said bandpass filtered first IF signal to up-convert said bandpass filtered first IF signal to a second IF signal at a second IF frequency, wherein said second IF frequency is greater than said first IF frequency; an output coupled to said second mixer output to provide an output signal from said second IF signal; **characterised in that** said low IF radio receiver circuit further comprises a single phase analog-to-digital converter coupled to said output, and wherein said second IF frequency is substantially twice said first IF frequency, said second IF frequency is substantially 2.048 MHz and said analogue-to-digital converter has a sampling frequency of substantially four times said second IF frequency.

As will be explained in more detail below, by employing two IF frequencies, the first IF frequency being lower than the second IF frequency, the image response can be kept close to a desired or target receive channel, whilst at the same time reducing the constraints on the anti-alias and image filtering in the analog domain prior to analog-to-digital conversion. The latter aim (reducing filter constraints) is facilitated by an increased IF frequency since, as will be explained below, this reduces the sharpness of the analog filtering cut-off needed. The former aim (keeping the image response close to the wanted channel) may appear paradoxical since it might be imagined that this would make filtering more difficult. However the constraint can be understood by recognizing that, in a practical system, it is frequently the case that the interference rejection required increases with frequency separation from the selected channel, and for this reason keeping the image response close to wanted channel can actually reduce the filtering requirements.

In preferred embodiments of the receiver circuit the band pass filter provides a quadrature output, and the second mixer is a quadrature mixer, receiving a quadrature input from the band pass filter and a quadrature input from the second local oscillator and providing a quadrature output at the second IF frequency. The circuit may then further comprise a combiner in particular a summer, to sum the quadrature signals at the second IF frequency to provide a single (phase) or real (rather than complex) summed output. This is preferably low-pass filtered to provide an IF output for the analog-to-digital conversion.

Preferably the band pass filter comprises a polyphase band pass filter having a pass band response for a target rf signal and an attenuating response for an image signal associated with the target. More particularly, the polyphase band pass filter is preferably centred on a positive frequency equalled to the first IF frequency. However in alternative arrangements a pair of bandpass filters forming part of an image rejecting I/Q mixer may be employed, in which case two real filters rather than a complex (polyphase) filter may be used. In such an embodiment the above-described summer maybe dispensed with, and the IF signal processed (and digitized) as a quadrature pair of signals, along similar lines to that shown in figure 1b.

The bandwidth requirements of DAB and the interference rejection required makes embodiments of the circuit particularly suitable for this application. In preferred embodiments the topology is arranged such that the circuit can be integrated on a single chip.

In a corresponding aspect the invention provides a method of receiving an rf signal using a low IF receiver, the method comprising : inputting said rf signal; downconverting said rf signal to a first, non-zero IF frequency, said first IF frequency being less than ten times a bandwidth of said rf signal; filtering said downconverted rf signal; upconverting said filtered downconverted rf signal to a second IF frequency, said second IF frequency being higher than said first IF frequency; providing said upconverted signal for demodulation; **characterised in that** the method further comprise converting a signal derived from said unconverted signal into a digital domain for said demodulation, said converting including sampling said signal derived from said upconverted signal at an even integral multiple of said second IF frequency, wherein said second IF frequency is substantially twice said first IF frequency, said second IF frequency is substantially 2.048 MHz and said sampling of said converting has a frequency of substantially four times said second IF frequency.

Preferably the filtering comprises band pass filtering to select a target RF signal to attenuate an image signal as previously described. Again as previously described, preferably the downconverting, filtering, and up converting operations are preferably performed on quadrature signals, which are then combined, and preferably low pass filtered, prior to demodulation. Preferably the rf signal comprises a data signal and the first IF frequency is less than three times the bandwidth of this signal.

These and other aspects of the first invention will now be further described, by way of example only, with reference to the accompanying figures in which:
Figures 1a and 1b show low-IF receivers employing a polyphase bandpass filter and a pair of real bandpass filters respectively;
Figure 2 shows a block diagram of an IF stage frequency conversion circuit for a low-IF frequency receiver according to an embodiment of the present invention;
Figure 3 shows a block diagram of a low-IF receiver integrated circuit incorporating the IF frequency conversion system of figure 2; and
Figure 4 shows an example of a low-IF digital audio broadcast receiver incorporating the integrated circuit of figure 3.

Background information on digital audio broadcast services can be found in the EUREKA-147 standard (ETSI Document EN300 401 V1.3.3 (2001-5); reference may also be made to BS EN 50248.2001. Digital audio broadcast services, for example, are provided in two frequency bands, 174 - 240 MHz (Band 3 in the UK) and 1452 -1492 MHz (L Band) for the rest of the world; it is also useful for a DAB receiver to be capable of receiving conventional FM (Frequency Modulation) broadcasts, in the UK at 88 - 108MHz.

As mentioned above, a conventional near zero IF receiver has a single low intermediate frequency which is comparable to the signal bandwidth. For the embodiment of the DAB receiver which we will describe the signal bandwidth is 1.536 MHz, however there are two conflicting requirements on the choice of low-IF frequency.

There is a first requirement which makes it beneficial to use lower (but still non-zero) IF frequencies. This requirement arises because the image response of a near zero IF receiver appears at an adjacent (or nearby) channel frequency and because, in many practical systems, the interference rejection required increases with frequency separation from the desired or target channel. For example, for a DAB receiver 35dB attenuation is required up to 5MHz from the desired channel, with 50dB attenuation thereafter. Thus, for example, a 1.024MHz IF frequency entails an image centred 2.048MHz away (that is just the other side of *dc),* extending from 1.28MHz to 2.816MHz. This frequency range requires only 35dB of attenuation, so only 35dB of image rejection is required. However were an IF frequency of 2.048MHz to be chosen, this would entail an image centred at 4.192MHz away, extending from 3.424MHz to 4.96MHz. In this case there is an overlap between the outermost OFDM (Orthogonal Frequency Division Multiplexed) bin of the DAB signal at 4.96MHz and an FM modulated interferer at 5MHz +/- 100KHz. This scenario would therefore require an image rejection of 50dB. However this would require a multiple pole filter which would have a relatively high power consumption and occupy a relatively large on-chip area; furthermore the power consumption and noise figure of an on-chip band pass filter both increase in proportion to the centre frequency.

The second, conflicting requirement is for an IF frequency which is high enough to be able to make efficient use of a single ADC (Analog-to-Digital Converter). A single ADC gives the best separation between the wanted signal and aliases (that is frequencies which are higher than the Niquist limit which are folded back into the frequency band) when the IF frequency is one quarter of the ADC sampling frequency. For DAB the lowest possible sampling frequency (for a single ADC) is 4.192MHz; this is determined by the highest frequency components in the signal in which it is necessary to capture. An IF frequency of one quarter of this value, that is 1.024MHz, requires very sharp cut-off anti-alias and image filtering in the analog domain, which consumes both power and chip area. The next convenient sampling frequency is 8.192MHz, which requires a fairly modest anti-alias filtering, and which entails an optimum IF frequency of 2.048MHz, which avoids over-burdensome image filtering.

For these reasons, as will be described further below, a preferred embodiment of a low-IF receiver for digital audio broadcasting has the frequency plan shown in table 1 below.

**Table 1**

| Frequency plan | |
|---|---|
| RF input | 170 - 240 MHz or 1452 - 1492 MHz |
| First local oscillator frequency | RF frequency + 1.024 MHz |
| First IF frequency | 1.024 MHz |
| Second local oscillator frequency | 1.024 MHz |
| Second IF frequency | 2.048 MHz |

This frequency plan covers both Band 3 and L Band DAB signals. The precise selection of IF frequencies of 1.024MHz and 2.048MHz is chosen for optimum sampling of the DAB OFDM signal, and also to conveniently interface with existing base band integrated circuits which are designed for an IF input at 2.048MHz.

In the above frequency plan, selecting the first IF frequency to be at 1.024mica keeps the image response close to the wanted channel, and then using a second, higher IF frequency of 2.048MHz reduces the amount of analog filtering required and facilitates a clean interface to base band signal processing circuitry.

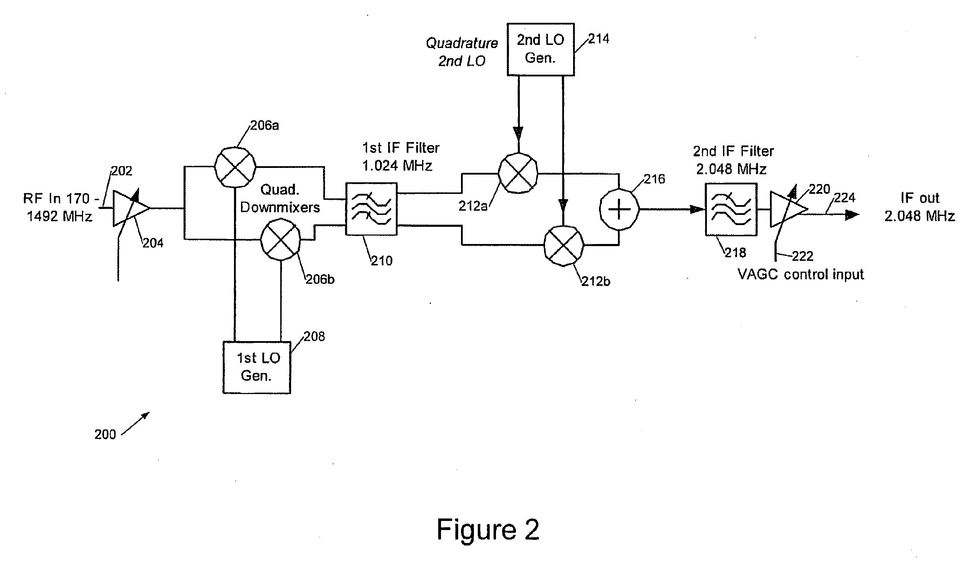

Referring now to figure 2, this shows a block diagram of a frequency conversion system 200 to implement the above described frequency plan.

The signal path begins with an rf input 202 at a frequency (in this example) of between 170MHz and 1492MHz, and this is provided to a variable gain LNA (low noise amplifier) 204. A particularly preferred ULNA implementation is described in the applicant co-pending UK Patent Application filed on the same day as this application.

The output of LNA 204 drives a quadrature downconversion mixer 206a, b, which receives quadrature inputs from a first local oscillator frequency generator 208; in general this will be tunable. The output of quadrature downconversion mixer 206 is a quadrature (I and Q) signal at the first IF Frequency, and this signal is provided to a first IF filter 210. Which comprises quadrature polyphase band pass filter centred at the first IF frequency. This filter passes positive frequency signals and attenuates negative frequency signals - that is it passes signals at the first IF frequency +1.024MHz, but attenuates signals at -1.024MHz.

The output of polyphase IF filter 210 is a quadrature signal at the first IF frequency, and this provided to a quadrature upconversion mixer 212a, b which performs a quadrature upconversion to the second IF frequency of 2.048MHz. Quadrature upconversion mixer 212 also receives a quadrature local oscillator signal from second local oscillator signal generator 214, which provides a quadrature output at 1.024MHz.

The quadrature outputs from mixer 212, at the second IF frequency, are combined in summer 216 and thence provided to a second IF filter 218 comprising a (real) low pass filter with a 3dB roll-off at the second IF frequency of 2.048MHz. The output of this filter is then provided to an automatic gain control (AGC) device 220 which applies a controllable gain/attenuation in response to a (voltage) signal on control input 222. The output 224 of AGC 220 provides a single phase (opposed to quadrature) IF output at 2.048MHz; this may then be provided to an ADC and subsequent digital signature processing circuitry for final down-conversion and demodulation in a conventional manner as outlined in figure 1a. Similarly the AGC 220 may be controlled by this DSP circuitry in a conventional manner (as is well known to those skilled in the art) to increase the dynamic range of the receiver.

In a preferred implementation the quadrature downconversion mixer 206 comprises a pair of Gilbert cell mixers of conventional design, with their rf inputs fed in parallel and their local oscillator inputs fed from the I and Q outputs of quadrature local oscillator generator 208. Preferably the polyphase band pass filter 210 is of a type described by Michiel Steyaert in "A Single Chip 900 MHz CMOS Receiver Front-End with a High Performance Low-IF Topology," IEEE Journal of Solid State Circuits, Vol. 30, No.12, December 1995, pp. 1483 - 1492; and Jan Crols, Michiel Steyaert "An Analog Integrated Polyphase Filter for a High Performance Low-IF Receiver," Proceedings of the VLSI Circuit Symposium Kyoto, June 1995, pp. 87-88; the entire contents of which are hereby incorporated by reference. The second mixer 212 may be implemented in a similar way to the first mixer 206. The second quadrature local oscillator generator 214 may likewise be implemented using any one of a range of conventional means well known to those skilled in the art.

The circuit 200 of figure 2 may be implemented in a single integrated circuit and in this case all the signal paths are preferably differential (as is common in rf integrated circuits). Thus preferably each signal in the block diagram of figure 2 is carried by a differential pair of connections on the chip, so that differential rf, LO (local oscillator) and IF signals are employed.

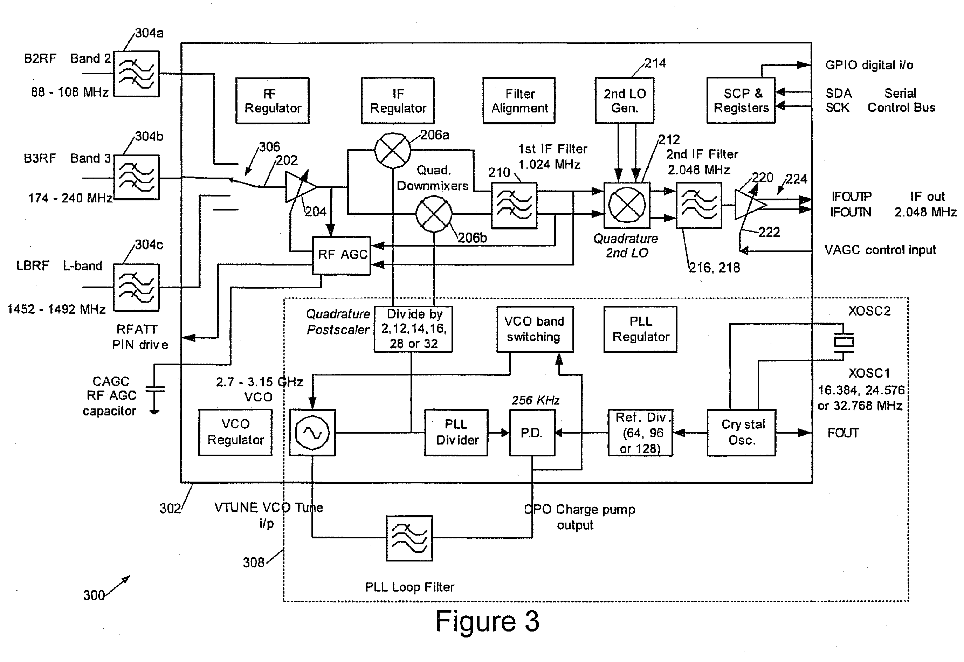

Referring now to figure 3, this shows a block diagram of a near zero IF receiver 300 (up to the IF stages) which includes an rf integrated circuit 302 incorporating the IF frequency conversion system shown in figure 2.

Referring to figure 3, the signal paths begin with a set of three off-chip band selection filters 304a, b, c for Band 2 (fm), Band 3, and L-Band respectively. One of these is selected by a multiplexer 306, generally under control of a base band integrated circuit, for further processing. The output of multiplex 306 provides an input 202 to the IF frequency conversion system, in which like elements to those of figure 2 are indicated by like reference numerals. The circuitry within dashed line 308 comprises the first local oscillator signal generator 208 of figure 2 and, in this preferred embodiment, is implemented by means of a phase locked loop (PLL) including an on-chip LC VCO (voltage control oscillator) with a crystal reference. A conventional PLL arrangement may be employed, but a preferred arrangement is described in the applicant's co-pending UK Patent Application filed on the same day as this application. Further details of the integrated circuit 302 of figure 3 are described below since these are helpful in understanding one application for the circuit of figure 2.

As previously described, the IF after downconversion is 1.024MHz for the DAB inputs (Band 3, L Baned), and it is 150KHz for the FM input (Band 2). After polyphase filtering the signal is upconverted to 2.048MHz for DAB and 2.198MHz for FM, and an IF variable gain amplifier and output driver provides a differential ADC drive for a subsequent base band I C. A PLL with on-chip LC VCO and a post divider generates the first LO signal for all bands, and this PLL, the second LO generation and the filter alignment are all reference to the crystal reference frequency (of 16.384, 24.576 or 32.768MHz).

There are three ULNA inputs, one for each frequency band. Each LNA has 40dB of AGC control range, and a P1dB of -15dBm. Without external AGC components the chip can meet the -25dBm high level input requirements for portable receivers; an off-chip PIN diode attenuator maybe used to extend the input range to -15 or -10dBm. The rf input filters may provide protection from ESD discharges to an external antenna.

As previously described, the IF filters combine the functions of channel selectivity, anti-alias filtering for the base band ADC and quadrature combining for image rejection. The first IF filter is a four-pole bandpass filter centred at 1.024MHz, with 3dB bandwidth of 1.9MHz to 270kHz. After the quadrature upconversion to the second IF, additional filtering is used to prevent aliasing. This is achieved with the second IF filter, which has an upper frequency of 2.048MHz and a bandwidth of 3.6MHz. A filter alignment circuit may be used to align the centre frequency and bandwidth of all IF filters to the crystal reference frequency. A calibration cycle may be run each time the PLL is re-programmed, or when the PLL or IF circuits are turned on. Periodically, say every half second, an on-die temperature sensor may be employed to take a reading and update the filter tuning.

A first AGC loop controls the rf AGC amplifier and the (optional) external PIN diode attenuator to avoid overloading of the RF and IF circuits; this detects signal levels at the first mixer input and at the first IF filter output. The IF AGC amplifier provides the final gain at the second IF. This is preferably controlled by the baseband IC to give a constant input level to the ADC on the baseband chip.

In a preferred implementation the frequency synthesizer includes an integer-N PLL comprising a fully integrated VCO, prescaler, phase detector, charge pump, reference divider and reference prescaler, and the loop filter is external. The reference divider divides down an externally provided reference frequency to a comparison frequency of 256kHz for all bands. The VCO output is divided by two for L-band, by 12, 14 or 16 for Band 3 and by 28 or 32 for Band 2. The quadrature output of this programmable divider feeds the quadrature downmixers. This results in a first IF frequency of 1.024MHz for all DAB bands (IF_{DAB}), and 150KHz for Band 2 FM mode. The second LO of 1.024MHz (DAB mode) or 2.048MHz (FM mode) for the upconverter is divided down from the reference frequency. This results in a second IF frequency of 2.048MHz for DAB and 2.198MHz for FM mode. The PLL and post-divider provide a channel frequency resolution of 64KHz for L-band and Band 3, and a 4KHz resolution for fine tuning in Band 2.

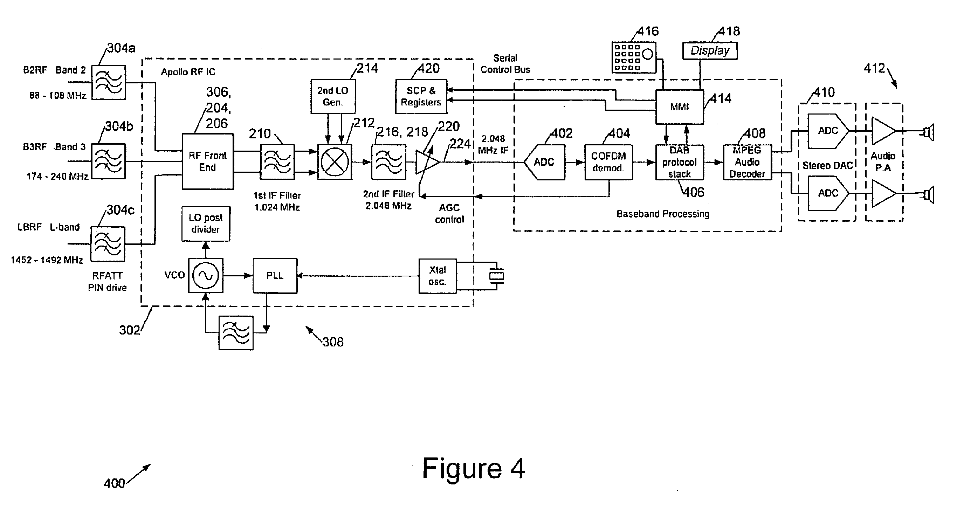

Figure 4 shows a block diagram of a DAB 400 receiver incorporating the IF frequency conversion system of figure 2. In figure 4 like elements to those of figures 2 and 3 are indicated by like reference numerals.

Referring to figure 4, the output 224 of AGC 220 is provided to analogue-to-digital converter 402 for digitisation and subsequent coded orthogonal frequency division multiplexed (COFDM) signal demodulation by COFDM demodulator block 404. The output of demodulator 404 is provided to a DAB protocol stack decoder 406, which in turn provides an MPEG datastream to MPEG audio decoder 408 which provides an audio output to stereo DAC 410 and audio amplifiers and speakers 412. A man machine interface (MMI) 414 interfaces with DAB protocol stack decoder 406 to provide a user keyboard 416 and display 418. These allow a user to interact with the receiver 400 via slave control processor and registers 420.

No doubt many other effective alternatives will occur to the skilled person. For example although embodiments of the described IF frequency conversion system combine the I and Q signals following the second (up-conversion) IF stage, these signals could be processed separately and provided to a pair of ADCs for subsequent digital downconversion and demodulation.

It will be understood that the invention is not limited the described embodiments and encompasses modifications apparent to those skilled in the art lying within the scope of the claims appended hereto.

## Claims

1. A low IF radio receiver circuit (200) for receiving digital audio broadcasts, the circuit comprising:
an rf input (202) for a received rf signal;
a first local oscillator (208) having a quadrature output to provide a quadrature first local oscillator signal at a first frequency;
a quadrature first mixer (206) coupled to said rf input and to said quadrature output of said first local oscillator and having a quadrature first mixer output, said first mixer and said first local oscillator being configured to provide quadrature mixing of said quadrature first local oscillator signal and said received rf signal to downconvert said received rf signal to a first quadrature IF signal at a first IF frequency;
a bandpass filter (210) coupled to said quadrature first mixer output and having a filtered output to provide a bandpass filtered first IF signal;
a second local oscillator (214) having a second local oscillator output, to provide a second local oscillator signal at a second frequency;
a second mixer (212) coupled to said filtered output of said bandpass filter (210) and to said second local oscillator (214) and having a second mixer output, said second mixer (212) and said second local oscillator (214) being configured to provide mixing of said second local oscillator signal and said bandpass filtered first IF signal to up-convert said bandpass filtered first IF signal to a second IF signal at a second IF frequency, wherein said second IF frequency is greater than said first IF frequency;
an output coupled to said second mixer output to provide an output signal from said second IF signal;
**characterised in that** said low IF radio receiver circuit further comprises a single phase analog-to-digital converter coupled to said output, and
wherein said second IF frequency is substantially twice said first IF frequency, said second IF frequency is substantially 2.048 MHz and said analogue-to-digital converter has a sampling frequency of substantially four times said second IF frequency.

2. A low IF radio receiver circuit as claimed is claim 1 wherein said filtered output of said bandpass filter (206) comprises a quadrature output, wherein said second local oscillator output comprises a quadrature output and said second local oscillator signal comprises a quadrature signal, wherein said second mixer (212) comprises a quadrature second mixer and said second mixer output comprises a quadrature output.

3. A low IF radio receiver circuit as claimed in claim 2 wherein said bandpass filter (210) comprises a polyphase bandpass filter having a passband response for a target rf signal for reception and an attenuating response for an image signal associated with said target rf signal.

4. A low IF radio receiver circuit as claimed in claim 3 wherein said polyphase bandpass filter has passband substantially cantered on a positive said first IF frequency and an attenuating response, relative to said passband, at a negative said first IF frequency.

5. A low-IF radio receiver circuit as claimed in any one of claims 2 to 4 further comprising a combiner (216) coupled to said quadrature second mixer output to combine quadrature components of said second mixer output to provide a single phase combined signal for said output.

6. A low-IF radio receiver circuit as claimed in claim 5 further comprising a low pass filter (218) coupled between an output of said combiner and said output, to low pass filter said combined signal.

7. A low-IF radio receiver circuit as claimed in any preceding claim integrated on a single chip.

8. A radio receiver including the low IF radio receiver circuit of any preceding claim.

9. A method of receiving an rf signal using a low IF receiver, the method comprising :
inputting said rf signal;
downconverting said rf signal to a first, non-zero IF frequency,
said first IF frequency being less than ten times a bandwidth of
said rf signal;
filtering said downconverted rf signal;
upconverting said filtered downconverted rf signal to a second IF frequency, said second IF frequency being higher than said first IF frequency;
providing said upconverted signal for demodulation;
**characterised in that** the method further comprises converting a signal derived from said upconverted signal into a digital domain for said demodulation, said converting including sampling said signal derived from said upconverted signal at an even integral multiple of said second IF frequency,
wherein said second IF frequency is substantially twice said first IF frequency, said second IF frequency is substantially 2.048 MHz and said sampling of said converting has a frequency of substantially four times said second IF frequency.

10. A method as claimed in claim 9 wherein said filtering comprises bandpass filtering to select a target rf signal and attenuate an image rf signal.

11. A method as claimed in claim 9 or 10 wherein said downconverting, filtering, and upconverting comprise quadrature downconverting, filtering, and upconverting, and wherein said filtering comprises polyphase filtering.

12. A method as claimed in claim 11 further comprising combining quadrature signals from said upconverting prior to providing said upconverted signal for demodulation.

13. A method as claimed in claim 12 further comprising low pass filtering said combined quadrature signals prior to providing said upconverted signal for demodulation.

14. A method as claimed in any one of claims 9 to 13 wherein said rf signal comprises a data signal, and wherein said first IF frequency is less than three times said bandwidth of said rf signal.

## Patentansprüche

1. Funkempfängerschaltung (200) mit niedriger Zwischenfrequenz (ZF) zum Empfangen von digitalen Audio-Rundfunksendungen, die Schaltung umfassend:
einen RF-Eingang (202) für ein empfangenes RF-Signal;
einen ersten Lokaloszillator (208) mit einem Quadraturausgang, um ein Quadratursignal des ersten Lokaloszillators auf einer ersten Frequenz bereitzustellen;
einen ersten Quadraturmischer (206), der an den RF-Eingang und an den Quadraturausgang des ersten Lokaloszillators gekoppelt ist und einen ersten Quadraturmischerausgang hat, wobei der erste Mischer und der erste Lokaloszillator dazu konfiguriert sind, Quadraturmischung des Quadratursignals des ersten Lokaloszillators und des empfangenen RF-Signals bereitzustellen, um das empfangene RF-Signal auf ein erstes ZF-Quadratursignal auf einer ersten ZF-Frequenz abwärtszuwandeln;
ein Bandpassfilter (210), das an einen ersten Quadraturmischerausgang gekoppelt ist und einen gefilterten Ausgang hat, um ein bandpassgefiltertes erstes ZF-Signal bereitzustellen;
einen zweiten Lokaloszillator (214) mit einem zweiten Lokaloszillatorausgang, um ein zweites Lokaloszillatorsignal auf einer zweiten Frequenz bereitzustellen;
einen zweiten Mischer (212), der an den gefilterten Ausgang des Bandpassfilters (210) und an den zweiten Lokaloszillator (214) gekoppelt ist und einen zweiten Mischerausgang hat, wobei der zweite Mischer (212) und der zweite Lokaloszillator (214) dazu angepasst sind, Mischung des zweiten Lokaloszillatorsignals und des bandpassgefilterten ersten ZF-Signals bereitzustellen, um das bandpassgefilterte erste ZF-Signal auf ein zweites ZF-Signal auf einer zweiten ZF-Frequenz aufwärtszuwandeln, worin die zweite ZF-Frequenz größer ist als die erste ZF-Frequenz;
einen Ausgang, der an einen zweiten Mischerausgang gekoppelt ist, um ein Ausgangssignal aus dem zweiten ZF-Signal bereitzustellen;
**dadurch gekennzeichnet, dass** die Funkempfängerschaltung mit niedriger ZF außerdem einen an den Ausgang gekoppelten einphasigen A/D-Wandler umfasst, und
worin die zweite ZF-Frequenz im Wesentlichen gleich der doppelten ersten ZF-Frequenz ist, die zweite ZF-Frequenz im Wesentlichen gleich 2,048 MHz ist und der A/D-Wandler eine Abtastfrequenz im Wesentlichen gleich dem Vierfachen der zweiten ZF-Frequenz hat.

2. Funkempfängerschaltung mit niedriger ZF nach Anspruch 1, worin der gefilterte Ausgang des Bandpassfilters (206) einen Quadraturausgang umfasst, der zweite Lokaloszillatorausgang einen Quadraturausgang und das zweite Lokaloszillatorsignal ein Quadratursignal umfasst, worin der zweite Mischer (212) einen zweiten Quadraturmischer und der zweite Mischerausgang einen Quadraturausgang umfasst.

3. Funkempfängerschaltung mit niedriger ZF nach Anspruch 2, worin das Bandpassfilter (210) ein Mehrphasen-Bandpassfilter umfasst, das für ein RF-Zielsignal zum Empfang ein Durchlassbandverhalten hat und für ein mit dem RF-Zielsignal assoziiertes Bildsignal ein Dämpfungsverhalten hat.

4. Funkempfängerschaltung mit niedriger ZF nach Anspruch 3, worin das Mehrphasen-Bandpassfilter das Durchlassband im Wesentlichen auf einer ersten ZF-Positivfrequenz zentriert hat und relativ zum Durchlassband ein Dämpfungsverhalten auf einer ersten ZF-Negativfrequenz hat.

5. Funkempfängerschaltung mit niedriger ZF nach einem der Ansprüche 2 bis 4, außerdem einen Kombinator (216) umfassend, der an den zweiten Quadraturmischerausgang gekoppelt ist, um Quadraturkomponenten des zweiten Mischerausgangs zu kombinieren, damit ein einphasiges kombiniertes Signal für den Ausgang bereitgestellt wird.

6. Funkempfängerschaltung mit niedriger ZF nach Anspruch 5, außerdem ein Tiefpassfilter (218) umfassend, das zwischen einen Ausgang des Kombinators und den Ausgang gekoppelt ist, um das kombinierte Signal mittels Tiefpass zu filtern.

7. Funkempfängerschaltung mit niedriger ZF nach einem vorhergehenden Anspruch, das auf einem Einzelchip integriert ist.

8. Funkempfänger, der die Funkempfängerschaltung mit niedriger ZF nach einem vorhergehenden Anspruch enthält.

9. Verfahren zum Empfangen eines RF-Signals unter Verwendung eines Empfängers mit niedriger ZF, das Verfahren umfassend:
Eingeben des RF-Signals;
Abwärtswandeln des RF-Signals auf eine erste von Null verschiedene ZF-Frequenz,
wobei die erste ZF-Frequenz kleiner ist als das Zehnfache einer Bandbreite des RF-Signals; Filtern des abwärtsgewandelten RF-Signals;
Aufwärtswandeln des gefilterten abwärtsgewandelten RF-Signals auf eine zweite ZF-Frequenz, wobei die zweite ZF-Frequenz höher ist als die erste ZF-Frequenz;
Bereitstellen des aufwärtsgewandelten Signals zur Demodulation;
**dadurch gekennzeichnet, dass** das Verfahren außerdem das Umwandeln eines vom aufwärtsgewandelten Signal abgeleiteten Signals in eine digitale Domäne zur Demodulation umfasst, wobei das Umwandeln das Abtasten des vom aufwärtsgewandelten Signal abgeleiteten Signals mit einem geraden ganzzahligen Vielfachen der zweiten ZF-Frequenz umfasst,
worin die zweite ZF-Frequenz im Wesentlichen das Doppelte der ersten ZF-Frequenz ist, die zweite ZF-Frequenz im Wesentlichen gleich 2,048 MHz ist und das Abtasten des Umwandelns eine Frequenz hat, die im Wesentlichen gleich dem Vierfachen der zweiten ZF-Frequenz ist.

10. Verfahren nach Anspruch 9, worin das Filtern Bandpassfiltern umfasst, um ein RF-Zielsignal auszuwählen und ein RF-Bildsignal zu dämpfen.

11. Verfahren nach Anspruch 9 oder 10, worin das Abwärtswandeln, Filtern und Aufwärtswandeln Quadraturabwärtswandeln, Filtern und Aufwärtswandeln umfasst und worin das Filtern Mehrphasenfiltern umfasst.

12. Verfahren nach Anspruch 11, das außerdem das Kombinieren von Quadratursignalen aus dem Aufwärtswandeln umfasst, bevor das aufwärtsgewandelte Signal zur Demodulation bereitgestellt wird.

13. Verfahren nach Anspruch 12, das außerdem das Tiefpassfiltern der kombinierten Quadratursignale umfasst, bevor das aufwärtsgewandelte Signal zur Demodulation bereitgestellt wird.

14. Verfahren nach einem der Ansprüche 9 bis 13, worin das RF-Signal ein Datensignal umfasst und worin die erste ZF-Frequenz kleiner ist als das Dreifache der Bandbreite des RF-Signals.

## Revendications

1. Circuit de récepteurs radio à basse fréquence intermédiaire (IF) (200) destiné à recevoir des diffusions audio numériques, le circuit comportant:
une entrée de radiofréquence (rf) (202) destinée à un signal rf reçu ;
un premier oscillateur local (208) présentant une sortie en quadrature de manière à fournir un signal de premier oscillateur local en quadrature à une première fréquence ;
un premier mélangeur en quadrature (206) couplé à ladite entrée rf et à ladite sortie en quadrature dudit premier oscillateur local et présentant une sortie de premier mélangeur en quadrature, ledit premier mélangeur et ledit premier oscillateur local étant configurés de manière à délivrer un mélange en quadrature dudit signal de premier oscillateur local en quadrature et dudit signal rf reçu pour convertir par abaissement ledit signal rf reçu en un premier signal IF en quadrature à une première fréquence IF ;
un filtre passe-bande (210) couplé à ladite sortie de premier mélangeur en quadrature et présentant une sortie filtrée pour délivrer un premier signal IF filtré par filtre passe-bande ;
un second oscillateur local (214) présentant une sortie de second oscillateur local pour fournir un signal de second oscillateur local à une seconde fréquence ;
un second mélangeur (212) couplé à ladite sortie filtrée dudit filtre passe-bande (210) et audit second oscillateur local (214) et présentant une sortie de second mélangeur, ledit second mélangeur (212) et ledit second oscillateur local (214) étant configurés de manière à délivrer un mélange dudit signal de second oscillateur local et dudit premier signal IF filtré par filtre passe-bande pour convertir par élévation ledit premier signal IF filtré par filtre passe-bande en un second signal IF à une seconde fréquence IF, dans lequel ladite seconde fréquence IF est supérieure à ladite première fréquence IF ;
une sortie couplée à ladite sortie de second mélangeur pour fournir un signal de sortie à partir dudit second signal IF ;
**caractérisé en ce que** ledit circuit de récepteurs radio à basse fréquence IF comporte en outre un convertisseur analogique - numérique à phase unique couplé à ladite sortie, et
dans lequel ladite seconde fréquence IF est sensiblement égale au double de ladite première fréquence IF, ladite seconde fréquence IF est sensiblement égale à 2,048 Mhz et ledit convertisseur analogique - numérique présente une fréquence d'échantillonnage sensiblement quatre fois supérieure à ladite seconde fréquence IF.

2. Circuit de récepteurs radio à basse fréquence intermédiaire (IF) selon la revendication 1, dans lequel ladite sortie filtrée dudit filtre passe-bande (206) comporte une sortie en quadrature, dans lequel ladite sortie de second oscillateur local comporte une sortie en quadrature et ledit signal de second oscillateur comporte un signal en quadrature, dans lequel ledit second mélangeur (212) comporte un second mélangeur en quadrature et ladite sortie de second mélangeur comporte une sortie en quadrature.

3. Circuit de récepteurs radio à basse fréquence intermédiaire (IF) selon la revendication 2, dans lequel ledit filtre passe-bande (210) comporte un filtre passe-bande à phases multiples présentant une réponse passe-bande pour un signal rf cible de réception et une réponse d'atténuation pour un signal d'image associé audit signal rf cible.

4. Circuit de récepteurs radio à basse fréquence intermédiaire (IF) selon la revendication 3, dans lequel ledit filtre passe-bande à phases multiples présente une bande de fréquences sensiblement centrée sur une fréquence positive de ladite première fréquence IF et une réponse d'atténuation, par rapport à ladite bande de fréquences, à une fréquence négative de ladite première fréquence IF.

5. Circuit de récepteurs radio à basse fréquence intermédiaire (IF) selon l'une quelconque des revendications 2 à 4, comportant en outre un combinateur (216) couplé à ladite sortie de second mélangeur en quadrature pour combiner des composantes en quadrature de ladite sortie de second mélangeur en vue de fournir un signal combiné à phase unique pour ladite sortie.

6. Circuit de récepteurs radio à basse fréquence intermédiaire (IF) selon la revendication 5, comportant en outre un filtre passe-bas (218) couplé entre une sortie dudit combinateur et ladite sortie, pour filtrer par filtre passe-bas ledit signal combiné.

7. Circuit de récepteurs radio à basse fréquence intermédiaire (IF) selon l'une quelconque des revendications précédentes, lequel circuit est intégré sur une puce unique.

8. Récepteur radio comportant le circuit de récepteurs radio à basse fréquence intermédiaire (IF) selon l'une quelconque des revendications précédentes.

9. Procédé destiné à recevoir un signal rf en faisant appel à un récepteur à basse fréquence IF, le procédé comporte les étapes ci-dessous consistant à :
entrer ledit signal rf ;
convertir par abaissement ledit signal rf en une première fréquence IF non nulle,
ladite première fréquence IF étant inférieure à dix fois une bande passante dudit signal rf ;
filtrer ledit signal rf converti par abaissement ;
convertir par élévation ledit signal rf filtré converti par abaissement en une seconde fréquence IF, ladite seconde fréquence IF étant supérieure à ladite première fréquence IF ;
fournir ledit signal converti par élévation pour une démodulation ;
**caractérisé en ce que** le procédé comporte en outre l'étape consistant à convertir un signal dérivé dudit signal converti par élévation dans un domaine numérique pour ladite démodulation, ladite conversion incluant l'échantillonnage dudit signal dérivé à partir dudit signal converti par élévation à un multiple entier pair de ladite seconde fréquence IF,
dans lequel ladite seconde fréquence IF est sensiblement égale au double de ladite première fréquence IF, ladite seconde fréquence IF est sensiblement égale à 2,048 Mhz et ledit échantillonnage de ladite conversion présente une fréquence sensiblement quatre fois supérieure à ladite seconde fréquence IF.

10. Procédé selon la revendication 9, dans lequel l'étape de filtrage comporte l'étape consistant à filtrer par filtre passe-bande en vue de sélectionner un signal rf cible et d'atténuer un signal rf d'image.

11. Procédé selon la revendication 9 ou 10, dans lequel ladite conversion par abaissement, ledit filtrage et ladite conversion par élévation comportent une conversion par abaissement en quadrature, un filtrage en quadrature et une conversion par élévation en quadrature, et dans lequel ledit filtrage comporte un filtrage à phases multiples.

12. Procédé selon la revendication 11, comportant en outre l'étape consistant à combiner des signaux en quadrature à partir de ladite conversion par élévation avant de fournir ledit signal converti par élévation pour une démodulation.

13. Procédé selon la revendication 12, comportant en outre l'étape consistant à filtrer par filtre passe-bas lesdits signaux en quadrature combinés avant de délivrer ledit signal converti par élévation pour une démodulation.

14. Procédé selon l'une quelconque des revendications 9 à 13, dans lequel ledit signal rf comporte un signal de données, et dans lequel ladite première fréquence IF est inférieure à trois fois ladite bande passante dudit signal rf.
